(19) Europäisches Patentamt
European Patent Office
Office européen des brevets

(11) **EP 4 083 643 B1**

(12) **EUROPEAN PATENT SPECIFICATION**

(45) Date of publication and mention
of the grant of the patent:
**07.02.2024 Bulletin 2024/06**

(21) Application number: **20914683.6**

(22) Date of filing: **25.12.2020**

(51) International Patent Classification (IPC):
**G01R 31/392** (2019.01)    **G01R 31/367** (2019.01)

(52) Cooperative Patent Classification (CPC):
**G01R 31/392; G01R 31/367;** G01R 31/387

(86) International application number:
**PCT/CN2020/139203**

(87) International publication number:
**WO 2021/143482 (22.07.2021 Gazette 2021/29)**

(54) **SOH TEST METHOD AND APPARATUS**

SOH-TSTESTVERFAHREN UND -VORRICHTUNG

PROCÉDÉ ET APPAREIL DE CONTRÔLE DE SOH

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.01.2020 CN 202010061587**

(43) Date of publication of application:
**02.11.2022 Bulletin 2022/44**

(73) Proprietor: **Yutong Bus Co., Ltd.
Zhengzhou, Henan 450061 (CN)**

(72) Inventors:
• **ZHAO, Shichao
Zhengzhou, Henan 450061 (CN)**
• **SUN, Yanyan
Zhengzhou, Henan 450061 (CN)**
• **ZHANG, Tao
Zhengzhou, Henan 450061 (CN)**
• **ZHOU, Xuesong
Zhengzhou, Henan 450061 (CN)**
• **ZHANG, Like
Zhengzhou, Henan 450061 (CN)**

(74) Representative: **Gulde & Partner
Patent- und Rechtsanwaltskanzlei mbB
Wallstraße 58/59
10179 Berlin (DE)**

(56) References cited:
CN-A- 105 974 326        CN-A- 106 443 497
CN-A- 106 597 305        CN-A- 106 649 962
CN-A- 106 772 100        CN-A- 107 317 057
CN-A- 107 478 999        CN-A- 111 175 666
JP-A- 2004 014 205

• **KARAGIANNOPOULOS STAVROS ET AL:
"Battery energy storage capacity fading and
control strategies for deterministic and
stochastic power profiles", 2016 POWER
SYSTEMS COMPUTATION CONFERENCE
(PSCC), POWER SYSTEMS COMPUTATION
CONFERENCE, 20 June 2016 (2016-06-20), pages
1-7, XP032944135, DOI:
10.1109/PSCC.2016.7540956 [retrieved on
2016-08-10]**
• **Zou Youlan: "Modeling and Parameter Estimation
of Retired Lithium-ion Power Battery Based on
Capacity, resistance and the State of Charge",
China Doctoral Dissertations Full-Text Database,
Engineering Science and Technology II, no. 12, 1
May 2014 (2014-05-01), pages 1-138,
XP055794637, ISSN: 1674-022X**

**Description**

**FIELD OF THE INVENTION**

The present invention relates to a state of health (SOH) test method and apparatus, belonging to the technical field of lithium ion batteries.

**BACKGROUND OF THE INVENTION**

As an emerging technology, new energy vehicles are developing rapidly. As the core components of new energy vehicles, power batteries are the focus of the entire new energy industry. With the gradual increase in the holdings of new energy vehicles, the life evaluation on the power batteries of new energy vehicles has become the focus and problems of industry research and development.

At present, the SOH evaluation on the power batteries of new energy vehicles is generally carried out in the following ways: 1. with the help of charging and discharging devices, the state of health of a battery is calibrated under constant environmental conditions, and the charging and discharging life is generally tested at 1C/1C according to the national standards; 2. the total amount of AH of a battery is determined by experimental evaluation, and the state of health is predicted by calculating the ratio of the cell throughput to the total amount of AH; 3. a life model is built through the depth of charge and the number of charges and discharges to predict the state of health; 4. the state of health of a lithium battery is predicted from the definition of internal resistance by using a Kalman filtering algorithm; and 5. with the help of sample data, a relationship model between SOH and voltage, impedance, etc. is built to predict the state of health of a lithium battery.

The various methods mentioned above analyze big data and calculate certain rules or predict and evaluate the SOH of a power battery according to certain standards. However, the behavior habit of each user is different, and during the actual operation of a vehicle, the working conditions are very complex and far from the rules and standards, resulting in inaccurate prediction and evaluation conclusions and large deviations from the actual SOH of power batteries.

Conventional methods are known from KARAGIANNOPOULOS STAVROS ET AL: "Battery energy storage capacity fading and control strategies for deterministic and stochastic power profiles', in Power Systems Computation Conference (PSCC), 20 June 2016, pages 1-7, XP032944135 and CN 106597305 A.

**SUMMARY OF THE INVENTION**

The objective of the present application is to provide an SOH test method and apparatus for solving the problem that the existing SOH test method is inaccurate.

To achieve the above objective, the present invention proposes an SOH test method, including the following steps: collecting user's historical behavior habit data, the historical behavior habit data including historical data when a power battery is shelved and historical data when the power battery is in operation; the historical data when the power battery is shelved including a shelved duration when the power battery is shelved, a SOC of the power battery before shelved, and a temperature of the power battery when shelved; the historical data when the power battery is in operation including a charge and discharge rate of the power battery in operation, a number of charge and discharge cycles, and a temperature of the power battery in operation; obtaining a storage capacity loss rate of the power battery within a set time period according to the historical data when the power battery is shelved within the set time period; obtaining an operation capacity loss rate of the power battery within the set time period according to the historical data when the power battery is in operation within the set time period; and superposing the storage capacity loss rate and the operation capacity loss rate to obtain a capacity loss rate of the power battery within the set time period, thereby realizing SOH test; a calculation process of the storage capacity loss rate of the power battery within the set time period is as follows: $Q_{storage\ loss} = A_e{}^{m_1(T_{shelved}-T_0)}e^{m_2(SOC_{shelved}-SOC_0)} * t^n$ where $Q_{storage\ loss}$ is the storage capacity loss rate of the power battery within the set time period; $T_{shelved}$ is an equivalent temperature of the power battery when shelved within the set time period; $SOC_{shelved}$ is an equivalent SOC of the power battery before shelved within the set time period; $t$ is an accumulated value of the shelved duration within the set time period; $n$ is an index parameter, which is determined by the chemical system of the power battery; $A$, $m_1$, and $m_2$ are correction constants; $T_0$ is a reference temperature of the power battery; and $SOC_0$ is a reference SOC of the power battery; a calculation formula for $SOC_{shelved}$ is as follows: $SOC_{sheived}=(SOC_1*t_1+SOC_2*t_2+SOC_3*t_3+\cdots+SOC_n*t_n)/(t_1+t_2+t_3+\cdots+t_n)$; where $SOC_1$, $SOC_2$, $SOC_3...SOC_n$ are the SOCs of the power battery before the 1st, 2nd, 3rd...n-th times of shelving within the set time period, $t_1, t_2, t_3...t_n$ are the shelved durations at the 1st, 2nd, 3rd...n-th times of shelving within the set time period; a calculation formula for $T_{shelved}$ is as follows: $T_{shelved}= (T_1*t_1+T_2*t_2+T_3*t_3+\cdots+T_n*t_n)/(t_1+t_2+t_3+\cdots+t_n)$; where $T_1$, $T_2$, $T_3...T_n$ are the temperatures of the power battery at the 1st, 2nd, 3rd... n-th times of shelving within the set time period; wherein an experimental database is obtained by experimenting on power batteries of the same type as the user's power battery, and the experimental database is fitted to obtain the $A$, $m_1$, and $m_2$; and wherein in order to reduce the amount of calculation and improve the efficiency of evaluation, the charge and discharge rate in operation in the historical data when the power battery is in operation within the set time period is time-weighted to obtain an equivalent charge and discharge rate in operation within the set time period; the temperature of the power battery in operation in the historical data when the power battery is in operation within the set time period is time-weighted to obtain an equivalent temperature of the power battery in operation within the set time period; and the operation capacity loss rate of the power battery within the set time period is obtained from the equivalent charge and discharge rate in operation and the equivalent temperature of the power battery in operation; Further, in order to improve the accuracy of calculation of the operation capacity loss rate, a calculation process of the operation capacity loss rate of the power battery within the set time period is as follows:

$$Q_{operation\ loss} = \alpha * e^{(\beta_1/C_{operation} - \beta_2/T_{operation})} * N^Z + (d_1 + e_1 T_{operation})(d_2 + e_2 C_{operation});$$

where $Q_{operation\ loss}$ is the operation capacity loss rate of the power battery within the set time period; $C_{operation}$ is the equivalent charge and discharge rate in operation within the set time period; $T_{operation}$ is the equivalent temperature of the power battery in operation within the set time period; $N$ is a number of charge and discharge cycles within the set time period, and $\alpha$, $Z$, $\beta_1$, $\beta_2$, $d_1$, $e_1$, $d_2$, and $e_2$ are correction constants; wherein an experimental database is obtained by experimenting on power batteries of the same type as the user's power battery, and the experimental database is fitted to obtain the $\alpha$, $Z$, $\beta_1$, $\beta_2$, $d_1$, $e_1$, $d_2$, and $e_2$.

In addition, the present invention further provides an SOH test apparatus, including a memory and a processor, the processor being configured to execute instructions stored in the memory to implement the above-mentioned SOH test method.

The beneficial effects are as follows: the use of the power battery by the user includes charging, discharging and shelving, so the historical data when the power battery is shelved and the historical data when the power battery is in operation are collected, the storage capacity loss rate is obtained from the historical data when shelved, and the operation capacity loss rate is obtained from the historical data in operation, which realizes the evaluation on the life of the power battery used by the user through the user's historical behavior habit data, and makes the SOH closer to the reality and the evaluation more accurate; and the evaluation can be used by background operators for analysis, and who can notify the user in time when the power battery needs maintenance, so as to prolong the service life of the power battery.

## BRIEF DESCRIPTION OF THE DRAWINGS

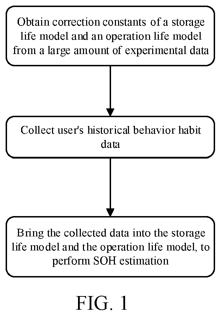

FIG. 1 is a flowchart of an SOH test method of the present invention.

## DETAILED DESCRIPTION OF THE EMBODIMENTS

Embodiment of SOH test method:

An SOH test method proposed in this embodiment, as shown in FIG. 1, includes the following steps:

1) User's historical behavior data is collected.

User's historical behavior habit data on a vehicle is uploaded to an operator's background through a network. The historical behavior habit data includes: a shelved duration when the power battery is shelved, a SOC of the power battery before shelved, and a temperature of the power battery when shelved, which are collectively referred to as historical data when shelved. The historical behavior habit data further includes: a charge and discharge rate in operation, a number of charge and discharge cycles, and a temperature of the power battery in operation, which are collectively referred to as historical data in operation. Because the charge and discharge rate = current/rated capacity of a power system, in order to obtain the charge and discharge rate in operation, the current needs to be obtained.

The historical data when shelved and the historical data in operation are acquired periodically, and the collection periods of the historical data when shelved and the historical data in operation are both 20s.

2) A storage capacity loss rate of the power battery is obtained according to the historical data when shelved.

The storage capacity loss rate is also the loss of life during storage, abbreviated as storage life. The storage life refers to the life of the power battery in a standby state, that is, the life of the power battery (referred to as a battery) at a reference temperature, without load and in an open-circuit state, and the storage life may also be understood as shelf life. The storage life mainly evaluates the influence of time passing on the performance of the battery in a certain temperature environment. The storage life is only related to the chemical system, temperature, storage time and SOC of the battery.

Because the SOH is generally evaluated after the power battery has been used for a period of time, an evaluation time, i.e. a set time period, is required. The storage capacity loss rate of the power battery within the set time period is obtained from the historical data when the power battery is shelved within the set time period, and the set time period may be set as required.

In this embodiment, in order to reduce the amount of calculation, the historical data when shelved within the set time period is processed. The processing process includes: the SOC of the power battery before shelved in the historical data when the power battery is shelved within the set time period is time-weighted to obtain an equivalent SOC of the power battery before shelved within the set time period; and the specific process of time-weighting is as follows:

$$SOC_{shelved} = (SOC_1 * t_1 + SOC_2 * t_2 + SOC_3 * t_3 + \cdots + SOC_n * t_n)/(t_1 + t_2 + t_3 + \cdots + t_n);$$

Where $SOC_{shelved}$ is the equivalent SOC of the power battery before shelved within the set time period, $SOC_1$, $SOC_2$, $SOC_3...SOC_n$ are the SOCs of the power battery before the 1st, 2nd, 3rd... n-th times of shelving within the set time period, $t_1$, $t_2$, $t_3...t_n$ are the shelved durations at the 1st, 2nd, 3rd... n-th times of shelving within the set time period.

The processing process further includes: the temperature of the power battery when shelved in the historical data when the power battery is shelved within the set time period is time-weighted to obtain an equivalent temperature of the power battery when shelved within the set time period; and the specific process of time-weighting is as follows:

$$T_{shelved} = (T_1 * t_1 + T_2 * t_2 + T_3 * t_3 + \cdots + T_n * t_n)/(t_1 + t_2 + t_3 + \cdots + t_n);$$

Where $T_{shelved}$ is the equivalent SOC of the power battery before shelved within the set time period, $T_1$, $T_2$, $T_3...T_n$ are the temperatures of the power battery at the 1st, 2nd, 3rd... n-th times of shelving within the set time period, and $t_1$, $t_2$, $t_3...t_n$ are the shelved durations at the 1st, 2nd, 3rd... n-th times of shelving within the set time period.

Then, the storage capacity loss rate of the power battery within the set time period is obtained from the equivalent SOC of the power battery before shelved and the equivalent temperature of the power battery when shelved. As other embodiments, the storage capacity loss rate may also be calculated separately for the data of each time shelving in the historical data when shelved within the set time period, and the calculation results are finally superimposed to obtain the storage capacity loss rate within the set time period, which is not limited in the present invention.

In this embodiment, the calculation of the storage capacity loss rate is based on a pre-built storage life model, and the storage capacity loss rate within the set time period is calculated according to the pre-built storage life model and the historical data when shelved. As other embodiments, the calculation may also be based on other models, which are not limited in the present invention. The storage life model is as follows:

$$Q_{storage\ loss} = A e^{m_1(T_{shelved} - T_0)} e^{m_2(SOC_{shelved} - SOC_0)} * t^n$$

Where $Q_{storage\ loss}$ is the storage capacity loss rate of the power battery within the set time period; $T_{shelved}$ is the equivalent temperature of the power battery when shelved within the set time period; $SOC_{shelved}$ is the equivalent SOC of the power battery before shelved within the set time period; $n$ is an index parameter, which is determined by the chemical system of the power battery; $t$ is an accumulated value of the shelved duration within the set time period, $t = t_1 + t_2 + t_3 + \cdots + t_n$ ; $A$, $m_1$, and $m_2$ are correction constants; $T_0$ is a reference temperature of the power battery; $SOC_0$ is a reference SOC of the power battery; and $T_0$ and $SOC_0$ are set for determining the correction constants in the model.

In the storage life model, the process of determining the correction constants is as follows: an experimental database is obtained by experimenting on power batteries of the same type as the user's power battery, and the experimental database is fitted to obtain the $A$, $m_1$, and $m_2$.

3) An operation capacity loss rate is obtained according to the historical data in operation.

Corresponding to the storage capacity loss rate, the operation capacity loss rate should also be the operation capacity loss rate within the set time period, and during the operation, the operation capacity loss rate is related to the temperature, charge and discharge rate, and number of charge and discharge cycles in operation.

In this embodiment, in order to reduce the amount of calculation, the historical data in operation within the set time period is processed. The processing process includes: the charge and discharge rate in operation in the historical data when the power battery is in operation within the set time period is time-weighted to obtain an equivalent charge and discharge rate in operation within the set time period. Of course, in order to achieve time-weighting, an operation duration in operation further needs to be obtained. The specific process of time-weighting is as follows:

$$C_{operation} = (C_1 * t_1' + C_2 * t_2' + C_3 * t_3' + \cdots + C_n * t_n')/(t_1' + t_2' + t_3' + \cdots + t_n');$$

Where $C_{operation}$ is the equivalent charge and discharge rate in operation within the set time period; $C_1$, $C_2$, $C_3 \ldots C_n$ are the charge and discharge rates at the 1st, 2nd, 3rd...n-th times of operation within the set time period, and $t_1$, $t_2$, $t_3 \ldots t_n$ are the operation durations at the 1st, 2nd, 3rd... n-th times of operation within the set time period.

The processing process further includes: the temperature of the power battery in operation in the historical data when the power battery is in operation within the set time period is time-weighted to obtain an equivalent temperature of the power battery in operation within the set time period. Of course, in order to achieve time-weighting, the operation duration in operation further needs to be obtained. The specific process of time-weighting is as follows:

$$T_{operation} = (T_1 * t_1' + T_2 * t_2' + T_3 * t_3' + \cdots + T_n * t_n')/(t_1' + t_2' + t_3' + \cdots + t_n');$$

Where $T_{operation}$ is the equivalent temperature of the power battery in operation within the set time period; $T_1$, $T_2$, $T_3 \ldots T_n$ are the temperatures of the power battery at the 1st, 2nd, 3rd... n-th times of operation within the set time period, and $t_1$, $t_2$, $t_3 \ldots t_n$ are the operation durations at the 1st, 2nd, 3rd... n-th times of operation within the set time period.

Then, the operation capacity loss rate of the power battery within the set time period is obtained from the equivalent charge and discharge rate in operation and the equivalent temperature of the power battery in operation. Of course, as other embodiments, the operation capacity loss rate may also be calculated separately for the data of each time of operation in the historical data in operation within the set time period, and the calculation results are finally superimposed to obtain the operation capacity loss rate within the set time period, which is not limited in the present invention.

In this embodiment, the calculation of the operation capacity loss rate is based on a pre-built operation life model, and the operation capacity loss rate within the set time period is calculated according to the pre-built operation life model and the historical data in operation. As other embodiments, the calculation may also be based on other models, which are not limited in the present invention. The operation life model is as follows:

$$Q_{operation\ loss} = \alpha * e^{(\beta_1/C_{operation} - \beta_2/T_{operation})} * N^Z + (d_1 + e_1 T_{operation})(d_2 + e_2 C_{operation});$$

Where $Q_{operation\ loss}$ is the operation capacity loss rate of the power battery within the set time period; $C_{operation}$ is the equivalent charge and discharge rate in operation within the set time period; $T_{operation}$ is the equivalent temperature of the power battery in operation within the set time period; $N$ is a number of charge and discharge cycles within the set time period (vehicle operation cumulative charge SOC/100), and $\alpha$, $Z$, $\beta_1$, $\beta_2$, $d_1$, $e_1$, $d_2$, and $e_2$ are correction constants.

The process of determining the specific values of $\alpha$, $Z$, $\beta_1$, $\beta_2$, $d_1$, $e_1$, $d_2$, and $e_2$ is as follows:
The operation life model in the present invention is based on the Arrhenius formula:

$$Q_{loss} = A' e^{(-E_a/RT')} * N^k;$$

Where $Q_{loss}$ is a loss rate, A' is a constant, $E_a$ is activation energy in J/mol, $R$ is a gas universal constant, T' is a temperature, $N$ is a number of cycles, and $k$ is a power function factor. Generally, $Z$ in the operation life model is equivalent to $k$.

When applied to the operation life model, first, after the charge and discharge rate and the number of cycles of the battery are determined, the life of the battery is only related to the temperature, and the influence of the temperature on the capacity decay rate of the battery conforms to the Arrhenius formula:

$$Q_{loss1} = A_1 e^{(-E_{a_1}/RT)} * N^k + a_1, \quad a_1 = d_1 + e_1 T;$$

Where $Q_{loss1}$ is an operation loss rate affected by temperature, $A_1$ is a temperature correction constant, $E_{a_1}$ is activation energy affected by temperature in J/mol, $R$ is the gas universal constant, $T$ is an operation temperature, $N$ is the number of cycles, $k$ is the power function factor, and $a_1$, $d_1$ and $e_1$ are correction constants, where $a_1$ is specifically a correction factor of battery capacity decay under different conditions and is derived from the formula derivation process. After the logarithm is taken, the following is obtained:

$$\ln(Q_{loss1} - a_1) = \ln A_1 - E_{a_1} / RT + k \ln N .$$

The power batteries of the same type as the user's power battery are experimented to obtain capacity loss rates of the power batteries at different temperatures, which are then fitted by a curve fitting method to obtain a fitted curve $Q_{loss1} = b_1 * N^{c_1} + a_1$ and constants $a_1$, $b_1$ and $c_1$. Logarithms are taken from two sides of the fitted curve to obtain:
$\ln(Q_{loss1} - a_1) = \ln b_1 + c_1 \ln N$ ; to obtain $c_1 = k$ ; $\ln b_1 = \ln A_1 - E_{a_1} / RT$ ; fitting is executed according to different temperatures $T$ and corresponding $b_1$, to obtain $A_1$ and $E_{a_1}$, and $\beta_2 = -E_{a_1} / R$ .
After $a_1$ at different test temperatures $T$ is obtained, the $T$ and $a_1$ are fitted to obtain a relational formula $a_1 = d_1 + e_1 T$ of $a_1$ and T, and then $d_1$ and $e_1$ are obtained.
Next, after the temperature and the number of cycles of the battery are determined, the life of the battery is only related to the charge and discharge rate, and the influence of the charge and discharge rate on the capacity decay rate of the battery also conforms to the Arrhenius formula:

$$Q_{loss2} = A_2 e^{(-E_{a_2}/RC)} * N^k + a_2 ; \quad a_2 = d_2 + e_2 C ;$$

Where $Q_{loss2}$ is the operation loss rate affected by the charge and discharge rate, $A_2$ is the correction constant of the charge and discharge rate, $E_{a_2}$ is activation energy affected by the charge and discharge rate in J/mol, $R$ is the gas universal constant, $C$ is the charge and discharge rate, $N$ is the number of cycles, $k$ is the power function factor, and $a_2$, $d_2$ and $e_2$ are correction constants, where $a_2$ is a correction factor of battery capacity decay under different conditions and is derived from the formula derivation process.
$A_2$, $E_{a_2}$ , $k$, $d_2$ and $e_2$ are determined as the above, i.e. determined by curve fitting, which is not repeated here. Generally, the $k$ value here is the same as the above $k$ value. The $k$ value is a power function factor, specifically the power function factor of the number of cycles, which is related to the decay mechanism of the battery and is affected by temperature. After the chemical system of the battery is determined, the $k$ value is not much different above 0°C. $\beta_1 = -E_{a_2} / R$, $\alpha = A_1 * A_2$ .
So far, the determination of $\alpha$, Z, $\beta_1$, $\beta_2$, $d_1$, $e_1$, $d_2$, and $e_2$ is completed.
4) The storage capacity loss rate and the operation capacity loss rate are superposed to obtain a capacity loss rate of the power battery within the set time period, thereby realizing SOH test.
Considering the actual use of the power battery, the life of the battery may be expressed by the capacity loss rate of the battery. When the capacity loss rate of the battery reaches the maximum, the life of the power battery will end, so the life $Q_{loss}$ of the power battery may be attributed to storage life and operation life:

$$Q_{loss} = Q_{storage\ loss} + Q_{operation\ loss}.$$

Embodiment of SOH test apparatus:

An SOH test apparatus proposed in this embodiment includes a memory and a processor, the processor being configured to execute instructions stored in the memory to implement the SOH test method.
The specific implementation process of the SOH test method is described in the above-mentioned embodiment of the SOH test method, and will not be repeated here.

**Claims**

1. An SOH test method, **characterized by** comprising the following steps:

collecting user's historical behavior habit data, the historical behavior habit data comprising historical data when a power battery is shelved and historical data when the power battery is in operation; the historical data when the power battery is shelved comprising a shelved duration when the power battery is shelved, a $SOC$ of the power battery before shelved, and a temperature of the power battery when shelved; the historical data when the power battery is in operation comprising a charge and discharge rate of the power battery in operation, a number of charge and discharge cycles, and a temperature of the power battery in operation;

obtaining a storage capacity loss rate of the power battery within a set time period according to the historical data when the power battery is shelved within the set time period;

obtaining an operation capacity loss rate of the power battery within the set time period according to the historical data when the power battery is in operation within the set time period;

superposing the storage capacity loss rate and the operation capacity loss rate to obtain a capacity loss rate of the power battery within the set time period, thereby realizing SOH test;

a calculation process of the storage capacity loss rate of the power battery within the set time period is as follows:

$$Q_{storage\ loss} = Ae^{m_1(T_{shelved}-T_0)}e^{m_2(SOC_{shelved}-SOC_0)} * t^n$$

where $Q_{storage\ loss}$ is the storage capacity loss rate of the power battery within the set time period; $T_{shelved}$ is an equivalent temperature of the power battery when shelved within the set time period; $SOC_{shelved}$ is an equivalent $SOC$ of the power battery before shelved within the set time period; $t$ is an accumulated value of the shelved duration within the set time period; $n$ is an index parameter, which is determined by the chemical system of the power battery; $A$, $m_1$, and $m_2$ are correction constants; $T_0$ is a reference temperature of the power battery; and $SOC_0$ is a reference SOC of the power battery; wherein the SOH test method is **characterised in that**:

a calculation formula for $SOC_{shelved}$ is as follows:

$$SOC_{shelved}=(SOC_1 * t_1 + SOC_2 * t_2 + SOC_3 * t_3 + \cdots + SOC_n * t_n)/(t_1 + t_2 + t_3 + \cdots + t_n);$$

where $SOC_1$, $SOC_2$, $SOC_3...SOC_n$ are the SOCs of the power battery before the 1st, 2nd, 3rd... n-th times of shelving within the set time period, $t_1$, $t_2$, $t_3...t_n$ are the shelved durations at the 1st, 2nd, 3rd... n-th times of shelving within the set time period;

a calculation formula for $T_{shelved}$ is as follows:

$$T_{shelved}=(T_1 * t_1 + T_2 * t_2 + T_3 * t_3 + \cdots + T_n * t_n)/(t_1 + t_2 + t_3 + \cdots + t_n);$$

where $T_1$, $T_2$, $T_3...T_n$ are the temperatures of the power battery at the 1st, 2nd, 3rd... n-th times of shelving within the set time period;

wherein an experimental database is obtained by experimenting on power batteries of the same type as the user's power battery, and the experimental database is fitted to obtain the $A$, $m_1$, and $m_2$;

wherein the charge and discharge rate in operation in the historical data when the power battery is in operation within the set time period is time-weighted to obtain an equivalent charge and discharge rate in operation within the set time period; the temperature of the power battery in operation in the historical data when the power battery is in operation within the set time period is time-weighted to obtain an equivalent temperature of the power battery in operation within the set time period; and the operation capacity loss rate of the power battery within the set time period is obtained from the equivalent charge and discharge rate in operation and the equivalent temperature of the power battery in operation;

wherein a calculation process of the operation capacity loss rate of the power battery within the set time period is as follows:

$$Q_{operation\ loss} = \alpha * e^{(\beta_1/C_{operation}-\beta_2/T_{operation})} * N^Z + (d_1 + e_1 T_{operation})(d_2 + e_2 C_{operation})$$

where $Q_{operation\ loss}$ is the operation capacity loss rate of the power battery within the set time period; $C_{operation}$ is the equivalent charge and discharge rate in operation within the set time period; $T_{operation}$ is the equivalent temperature of the power battery in operation within the set time period; $N$ is a number of charge and discharge cycles within the set time period, and $\alpha$, $Z$, $\beta_1$, $\beta_2$, $d_1$, $e_1$, $d_2$, and $e_2$ are correction constants; and

wherein an experimental database is obtained by experimenting on power batteries of the same type as the user's power battery, and the experimental database is fitted to obtain the $\alpha$, $Z$, $\beta_1$, $\beta_2$, $d_1$, $e_1$, $d_2$, and $e_2$.

**2.** An SOH test apparatus, **characterized by** comprising a memory and a processor, the processor being configured to execute instructions stored in the memory to implement the SOH test method according to claim 1.

**Patentansprüche**

**1.** SOH-Testverfahren, **dadurch gekennzeichnet, dass** es die folgenden Schritte umfasst:

Sammeln von historischen Verhaltensgewohnheitsdaten eines Benutzers, wobei die historischen Verhaltensgewohnheitsdaten historische Daten umfassen, wenn eine Leistungsbatterie gelagert ist, und historische Daten, wenn die Leistungsbatterie in Betrieb ist; wobei die historischen Daten, wenn die Leistungsbatterie gelagert ist, eine Lagerungsdauer, wenn die Leistungsbatterie gelagert ist, einen *SOC* der Leistungsbatterie vor der Lagerung und eine Temperatur der Leistungsbatterie, wenn sie gelagert ist, umfassen; wobei die historischen Daten, wenn die Leistungsbatterie in Betrieb ist, eine Lade- und Entladerate der Leistungsbatterie im Betrieb, eine Anzahl von Lade- und Entladezyklen und eine Temperatur der Leistungsbatterie im Betrieb umfassen;
Erhalten einer Speicherkapazitätsverlustrate der Leistungsbatterie innerhalb eines eingestellten Zeitraums gemäß den historischen Daten, wenn die Leistungsbatterie innerhalb des eingestellten Zeitraums gelagert wird;
Erhalten einer Betriebskapazitätsverlustrate der Leistungsbatterie innerhalb des eingestellten Zeitraums gemäß den historischen Daten, wenn die Leistungsbatterie innerhalb des eingestellten Zeitraums in Betrieb ist;
Überlagern der Speicherkapazitätsverlustrate und der Betriebskapazitätsverlustrate, um eine Kapazitätsverlustrate der Leistungsbatterie innerhalb des eingestellten Zeitraums zu erhalten, wodurch ein SOH-Test durchgeführt wird;
wobei ein Berechnungsprozess der Speicherkapazitätsverlustrate der Leistungsbatterie innerhalb des eingestellten Zeitraums wie folgt ist:

$$Q_{storage\ loss} = Ae^{m_1(T_{shelved}-T_0)}e^{m_2(SOC_{shelved}-SOC_0)} * t^n$$

wobei $Q_{storage\ loss}$ die Speicherkapazitätsverlustrate der Leistungsbatterie innerhalb des eingestellten Zeitraums ist; $T_{shelved}$ eine äquivalente Temperatur der Leistungsbatterie ist, wenn sie innerhalb des eingestellten Zeitraums gelagert wird; $SOC_{shelved}$ ein äquivalenter *SOC* der Leistungsbatterie vor der Lagerung innerhalb des eingestellten Zeitraums ist; $t$ ein akkumulierter Wert der Lagerungsdauer innerhalb des eingestellten Zeitraums ist; $n$ ein Indexparameter ist, der durch das chemische System der Leistungsbatterie bestimmt wird; $A$, $m_1$ *und* $m_2$ Korrekturkonstanten sind; $T_0$ eine Referenztemperatur der Leistungsbatterie ist; und $SOC_0$ ein Referenz-SOC der Leistungsbatterie ist; wobei das SOH-Testverfahren **dadurch gekennzeichnet ist, dass**:

eine Berechnungsformel für $SOC_{shelved}$ wie folgt ist:

$$\mathrm{SOC}_{shelved} = (SOC_1 * t_1 + SOC_2 * t_2 + SOC_3 * t_3 + \cdots + SOC_n * t_n)/(t_1 + t_2 + t_3 + \cdots + t_n);$$

wobei $SOC_1$, $SOC_2$, $SOC_3...SOC_n$ die SOCs der Leistungsbatterie vor dem 1., 2., 3...n-ten Lagerungszeitpunkt innerhalb des eingestellten Zeitraums sind, $t_1$, $t_2$, $t_3...t_n$ die Lagerungsdauern zum 1., 2., 3...n-ten Lagerungszeitpunkt innerhalb des eingestellten Zeitraums sind;
wobei eine Berechnungsformel für $T_{shelved}$ wie folgt ist:

$$\mathrm{T}_{shelved} = (T_1 * t_1 + T_2 * t_2 + T_3 * t_3 + \cdots + T_n * t_n)/(t_1 + t_2 + t_3 + \cdots + t_n);$$

wobei $T_1$, $T_2$, $T_3...T_n$ die Temperaturen der Leistungsbatterie zum 1., 2., 3...n-ten Mal der Lagerung innerhalb des eingestellten Zeitraums sind;
wobei eine Versuchsdatenbank durch Versuche mit Leistungsbatterien desselben Typs wie die Leistungsbatterie des Benutzers erhalten wird, und die Versuchsdatenbank angepasst wird, um $A$, $m_1$ und $m_2$ zu erhalten;
wobei die Lade- und Entladerate im Betrieb in den historischen Daten, wenn die Leistungsbatterie innerhalb des eingestellten Zeitraums in Betrieb ist, zeitgewichtet wird, um eine äquivalente Lade- und Entladerate im Betrieb innerhalb des eingestellten Zeitraums zu erhalten; die Temperatur der Leistungsbatterie im Betrieb in den historischen Daten, wenn die Leistungsbatterie innerhalb des eingestellten Zeitraums in Betrieb ist, zeitgewichtet wird, um eine äquivalente Temperatur der Leistungsbatterie im Betrieb innerhalb des eingestellten Zeitraums zu erhalten; und die Betriebskapazitätsverlustrate der Leistungsbatterie innerhalb des eingestellten Zeitraums aus der äquivalenten Lade- und Entladerate im Betrieb und der äquivalenten Temperatur der Leistungsbatterie im Betrieb erhalten wird;

wobei ein Berechnungsprozess der Betriebskapazitätsverlustrate der Leistungsbatterie innerhalb des eingestellten Zeitraums wie folgt abläuft:

$$Q_{operation\,loss} = \alpha * e^{(\beta_1/C_{operation} - \beta_2/T_{operation})} * N^Z + (d_1 + e_1 T_{operation})(d_2 + e_2 C_{operation})$$

wobei $Q_{operation\,loss}$ die Betriebskapazitätsverlustrate der Leistungsbatterie innerhalb des eingestellten Zeitraums ist; $C_{operation}$ die äquivalente Lade- und Entladerate im Betrieb innerhalb des eingestellten Zeitraums ist; $T_{operation}$ die äquivalente Temperatur der Leistungsbatterie im Betrieb innerhalb des eingestellten Zeitraums ist; $N$ eine Anzahl von Lade- und Entladezyklen innerhalb des eingestellten Zeitraums ist, und $\alpha Z$, $\beta_1$, $\beta$, $d$, $e$, $d_2$ und $e_2$ Korrekturkonstanten sind; und

wobei eine experimentelle Datenbank durch Experimente mit Leistungsbatterien des gleichen Typs wie die Leistungsbatterie des Benutzers erhalten wird, und die experimentelle Datenbank angepasst wird, um $\alpha Z$, $\beta_1$, $\beta_2$, $d_1$, $e_1$, $d_2$, und $e_2$ zu erhalten.

2. SOH-Testvorrichtung, **dadurch gekennzeichnet, dass** sie einen Speicher und einen Prozessor umfasst, wobei der Prozessor so konfiguriert ist, dass er im Speicher gespeicherte Instruktionen ausführt, um das SOH-Testverfahren nach Anspruch 1 zu implementieren.

**Revendications**

1. Procédé de test SOH, **caractérisé par** comprenant les étapes suivantes :

collecter des données relatives aux habitudes de comportement d'un 'utilisateur, les données relatives aux habitudes de comportement comprenant des données historiques lorsqu'une batterie d'alimentation est stockée et des données historiques lorsque la batterie d'alimentation est en fonctionnement ; les données historiques lorsque la batterie d'alimentation est stockée comprennent une durée de stockage lorsque la batterie d'alimentation est stockée, un *SOC* de la batterie d'alimentation avant le stockage et une température de la batterie d'alimentation lorsqu'elle est stockée ; les données historiques lorsque la batterie d'alimentation est en fonctionnement comprennent un taux de charge et de décharge de la batterie d'alimentation en fonctionnement, un nombre de cycles de charge et de décharge, et une température de la batterie d'alimentation en fonctionnement ;

obtenir un taux de perte de capacité de stockage de la batterie d'alimentation au cours d'une période de temps donnée en fonction des données historiques lorsque la batterie d'alimentation est stockée au cours de la période de temps donnée ;

obtenir un taux de perte de capacité de fonctionnement de la batterie d'alimentation au cours de la période de temps définie en fonction des données historiques lorsque la batterie d'alimentation est en fonctionnement au cours de la période de temps définie ;

superposer le taux de perte de capacité de stockage et le taux de perte de capacité de fonctionnement pour obtenir un taux de perte de capacité de la batterie d'alimentation dans la période de temps définie, réalisant ainsi le test SOH ;

le processus de calcul du taux de perte de capacité de stockage de la batterie d'énergie au cours de la période de temps définie étant le suivant :

$$Q_{storage\,loss} = Ae^{m_1(T_{shelved} - T_0)} e^{m_2(SOC_{shelved} - SOC_0)} * t^n$$

où $Q_{storage\,loss}$ est le taux de perte de capacité de stockage de la batterie d'alimentation pendant la période de temps définie ; $T_{shelved}$ est une température équivalente de la batterie d'alimentation lorsqu'elle est stockée pendant la période de temps définie ; $SOC_{shelved}$ est un *SOC* équivalent de la batterie d'alimentation avant d'être stockée pendant la période de temps définie ; $t$ *est une* valeur accumulée de la durée de stockage dans la période de temps définie ; $n$ est un paramètre d'indice, qui est déterminé par le système chimique de la batterie d'alimentation ; $A$, $m_1$, et $m_2$ sont des constantes de correction ; $T_0$ est une température de référence de la batterie d'alimentation ; et $SOC_0$ est un SOC de référence de la batterie d'alimentation ; dans lequel le procédé de test SOH est **caractérisé en ce que** :

une formule de calcul pour $SOC_{shelved}$ est la suivante :

$$\mathrm{SOC}_{shelved}=(SOC_1 * t_1 + SOC_2 * t_2 + SOC_3 * t_3 + \cdots + SOC_n * t_n)/(t_1 + t_2 + t_3 + \cdots + t_n) \ \ ;$$

où $SOC_1$, $SOC_2$, $SOC_3...SOC_n$ sont les SOC de la batterie d'alimentation avant les 1ère, 2ème, 3ème ...n-ième temps de stockage dans la période de temps définie, $t_1$, $t_2$, $t_3...t_n$ sont les durées de stockage aux 1ère, 2ème, 3ème ...n-ième temps de stockage dans la période de temps définie ;
une formule de calcul pour $T_{shelved}$ est la suivante :

$$\mathrm{T}_{shelved}=(T_1 * t_1 + T_2 * t_2 + T_3 * t_3 + \cdots + T_n * t_n)/(t_1 + t_2 + t_3 + \cdots + t_n) \ \ ;$$

où $T_1$, $T_2$, $T_3...T_n$ sont les températures de labatterie d'alimentation aux 1er, 2e, 3e...n-ième moments du stockage au cours de la période de temps définie ;
dans lequel une base de données expérimentale est obtenue en expérimentant sur des batteries d'alimentation du même type que la batterie d'alimentation de l'utilisateur, et la base de données expérimentale est ajustée pour obtenir $A$, $m_1$, et $m_2$;
dans lequel le taux de charge et de décharge en fonctionnement dans les données historiques lorsque la batterie d'alimentation est en fonctionnement dans la période de temps définie est pondéré dans le temps pour obtenir un taux de charge et de décharge équivalent en fonctionnement dans la période de temps définie ; la température de la batterie d'alimentation en fonctionnement dans les données historiques lorsque la batterie d'alimentation est en fonctionnement dans la période de temps définie est pondérée dans le temps pour obtenir une température équivalente de la batterie d'alimentation en fonctionnement dans la période de temps définie ; et le taux de perte de capacité de fonctionnement de la batterie d'alimentation dans la période de temps définie est obtenu à partir du taux de charge et de décharge équivalent en fonctionnement et de la température équivalente de la batterie d'alimentation en fonctionnement ;
dans lequel un processus de calcul du taux de perte de capacité de fonctionnement de la batterie d'alimentation au cours de la période de temps définie est le suivant :

$$Q_{operation\ loss} = \alpha * e^{(\beta_1/C_{operation} - \beta_2/T_{operation})} * N^Z + (d_1 + e_1 T_{operation})(d_2 + e_2 C_{operation})$$

où $Q_{operation\ loss}$ est le taux de perte de capacité de fonctionnement de la batterie d'alimentation dans la période de temps définie ; $C_{operation}$ est le taux de charge et de décharge équivalent en fonctionnement dans la période de temps définie ; $T_{operation}$ est la température équivalente de la batterie d'alimentation en fonctionnement dans la période de temps définie ; $N$ est un nombre de cycles de charge et de décharge dans la période de temps définie, et $\alpha Z$, $\beta_1$, $\beta_2$, $d_1$, $e_1$, $d_2$, et $e_2$ sont des constantes de correction ; et dans lequel une base de données expérimentale est obtenue en expérimentant sur des batteries d'alimentation du même type que la batterie d'alimentation de l'utilisateur, et la base de données expérimentale est ajustée pour obtenir le : $\alpha Z$, $\beta_1$, $\beta_2$, $d_1$, $e_1$, $d_2$, et $e_2$.

2. Dispositif de test SOH, **caractérisé en ce qu'**il comprend une mémoire et un processeur, le processeur étant configuré pour exécuter des instructions stockées dans la mémoire pour mettre en oeuvre le procédé de test SOH selon la revendication 1.

Obtain correction constants of a storage life model and an operation life model from a large amount of experimental data

↓

Collect user's historical behavior habit data

↓

Bring the collected data into the storage life model and the operation life model, to perform SOH estimation

FIG. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 106597305 A

**Non-patent literature cited in the description**

• **KARAGIANNOPOULOS STAVROS et al.** Battery energy storage capacity fading and control strategies for deterministic and stochastic power profiles. *Power Systems Computation Conference (PSCC),* 20 June 2016, 1-7